Europäisches Patentamt

European Patent Office

Office européen des brevets

(11) Veröffentlichungsnummer: **0 070 846**
**B1**

(12) **EUROPÄISCHE PATENTSCHRIFT**

(45) Veröffentlichungstag der Patentschrift:
04.02.87

(51) Int. Cl.⁴: **G 01 R 19/00, H 03 F 1/56**

(21) Anmeldenummer: **82900340.9**

(22) Anmeldetag: **04.02.82**

(86) Internationale Anmeldenummer:
**PCT/CH 82/00017**

(87) Internationale Veröffentlichungsnummer:
**WO 82/02775 (19.08.82 Gazette 82/20)**

(54) SERIE-PARALLEL GEGENGEKOPPELTER MESSKREIS UND VERWENDUNG DES MESSKREISES ZUM MESSEN VON SPANNUNGEN AN ELEKTROCHEMISCHEN ZELLEN.

(30) Priorität: **05.02.81 DE 3103887**

(43) Veröffentlichungstag der Anmeldung:
**09.02.83 Patentblatt 83/6**

(45) Bekanntmachung des Hinweises auf die Patenterteilung:
**04.02.87 Patentblatt 87/6**

(84) Benannte Vertragsstaaten:
**AT BE CH DE FR GB LI LU NL SE**

(56) Entgegenhaltungen:
US-A-2 011 315
US-A-3 737 798

REVIEW OF SCIENTIFIC INSTRUMENTS, vol. 51,
February 1980, New York (US), R.W. Pasco u.a.
"Circuit for the measurement of surface potential
changes by the static capacitor method", pages
246-249
PROC.IEE-REVIEWS, vol. 126, November 1979,
Stevenage (GB), R.W.J. Barker: "Modern
electrometer techniques", pages 1053-1068
ELECTRONICS, vol. 52, 27 September 1979, New
York (US), R. Miles: "Supersensitive measurement
demands critical input design", pages 145-149
ELEKTRONIK, vol. 24, April 1975, MÜNCHEN (DE),
K. Cammann: "Hinweise zur elektronischen pH-
und Ionenmesstechnik", pages 79-83
Druckschrift der Fa. Kontron

(73) Patentinhaber: **TROESCH, Jacques J.,
Walchestrasse 19, CH- 8035 Zürich (CH)**

(72) Erfinder: **TROESCH, Jacques J., Walchestrasse 19,
CH- 8035 Zürich (CH)**

(74) Vertreter: **Troesch, Hans Alfred, Dr. Ing.,
Walchestrasse 19, CH- 8035 Zürich (CH)**

(56) Entgegenhaltungen: (Fortsetzung)
"Operationsverstärker und ihre
Schaltungstechnik", 3. Auflage, S. 23
Handbuch für elektrisches Messen mechanischer
Grössen von Ch. Rohrbach, 1967, VDI-Verlag,
Düsseldorf, S. 295-302
Applications of Operational Amplifiers aus Burr-
Brown Electronics series, McGraw-Hill, 1973, S. 42

## Beschreibung

Die vorliegende Erfindung betrifft einen serie-parallel gegengekoppelten Messkreis zum Messen einer elektrischen Spannung, wobei die zu messende Spannung in Serie mit einer ihr gegenwirkenden Ausgangsspannung des Messkreises auf einen Eingang eines Verstärkers wirkt und die Ausgangsspannung als Messignal abgegriffen wird.

Es ist bekannt, durch serie-parallel gegengekoppelte Verstärkerkreise, deren Eingangsimpedanz zu erhöhen. Ein typisches Beispiel dafür ist die Schaltung von Operationsverstärkern als Folger. Diese Schaltung hat jedoch den Nachteil, dass beim Anlegen einer zu messenden Spannungsquelle an den Folgereingang deren ganzes Ausgangssignal über der Eingangsimpedanz des Verstärkers liegt, so dass die für die zu messende Quelle effektiv erscheinende Eingangsimpedanz nach oben durch die Gleichtaktimpedanz des Verstärkers beschränkt ist. In "applications of operational amplifiers" aus "Burr-Brown, Electronics Series, McGraw-Hill, 1973", Seite 42 ist zur Behebung dieses Nachteils bei Folgerschaltungen ein Schaltungsprinzip bekannt geworden, bei welchem die auszumessende Spannungsquelle zwischen den invertierenden Eingang und den Ausgang eines Operationsverstärkers geschaltet wird, wobei der nichtinvertierende Eingang beispielsweise auf Masse geschaltet ist. Am Ausgang des Verstärkers erscheint dann eine Spannung, die gleich der auszumessenden ist, wobei über der differentiellen Eingangsimpedanz des Verstärkers lediglich die sehr kleine Regeldifferenz liegt. Die in dieser Schaltung von der auszumessenden Signalquelle her gesehenen Impedanzen sind einerseits die um die Verstärkung des offenen Regelkreises hochtransformierte differentielle Eingangsimpedanz des Verstärkers und, über der Quelle liegend, die Impedanz zwischen invertierendem Eingang und Ausgang des Verstärkers, welch letztere schon wegen der geometrischen Anordnung von Ein- und Ausgang an integrierten Verstärkern, mit relativ kleinem Abstand, nicht zu vernachlässigen sein dürfte.

Aus "REVIEW OF SCIENTIFIC INSTRUMENTS", vol. 51, February 1980, New York (US), R.W. Pasco u.a: "Circuit for the measurement of surface potential changes by the static capacitor method", Seiten 246 bis 249 ist ein Messkreis eingangsgenannter Art bekannt geworden, bei welchem, dem Serie-Parallel-Gegenkopplungsprinzip folgend, einer zu messenden elektrischen Spannung an einer kapazitiven Zelle eine ihr gegenwirkende Ausgangsspannung gegengekoppelt wird. Dabei wird die Differenz aus Ausgangsspannung des Messkreises und zu messender Spannung, ein Spannungssignal einem per definitionem hochohmigen, als Folger ausgebildeten, Spannungsverstärker zugeführt, dessen Ausgang auf einen Regler wirkt, derart, dass die erscheinende Ausgangsspannung der zu messenden folgt. An einem derartig gegengekoppelten Messkreis ist die Folgegenauigkeit durch die Verstärkung des offenen Regelkreises gegeben, d.h. durch die Verstärkung, mit welcher, bei Öffnung der Gegenkopplung, die Ausgangsspannung auf die Eingangs- bzw. die zu messende Spannung reagiert. Ebenso wird die Schnelligkeit, mit welcher die Ausgangsspannung auf Änderungen der Eingangsspannung reagiert, u.a. durch den Frequenzgang dieser Verstärkung gegeben. Der erwähnte Messkreis stellt eine extrem hohe Eingangsimpedanz für die auszumessende Quelle dar, indem die Innenimpedanz dieser Quelle, der Zelle, durch die Verstärkung des offenen Regelkreises verstärkt wird. Bezüglich der Auslegung der für die Messgenauigkeit statisch und dynamisch ausschlaggebenden Verstärkung des offenen Regelkreises, ist jedoch dieser Messkreis nachteilig: Bedingt durch die Eingangsimpedanz des eingangsseitig hochohmigen Spannungsverstärkers - zur Erfassung eines Spannungssignals naheliegenderweise eingesetzt - entsteht, mit der Quelleninnenimpedanz, ein Spannungsteiler, so dass ein nur relativ geringer Bruchteil der Differenzspannung an den Spannungsverstärkereingang angelegt erscheint und durch die nachfolgenden Stufen verstärkt wird. Diese Signalabschwächung muss für gutes statisches und dynamisches Folgeverhalten durch nachfolgende Reglerstufen kompensiert werden. Dabei ist den relativ schlecht definierten Impedanzverhältnissen am Eingang des Spannungsverstärkers bezüglich Schwingneigung des Regelkreises Rechnung zu tragen.

Im weiteren ist aus der Druckschrift der Fa. KONTRON GmbH & Co. KG: "Operationsverstärker und ihre Schaltungstechnik", W. Schaufelberger, 3. Auflage, Seite 23 bekannt, dass mittels Operationsverstärkern realisierte, invertierende Verstärker, als Spannungsverstärker, eine Eingangsimpedanz entsprechend der dem invertierenden Eingang vorgeschalteten Impedanz aufweisen.

Aus der US-PS 2 011 315 ist weiter ein Messkreis bekannt geworden, der ebenfalls auf dem Prinzip der Serie-Parallel-Gegenkopplung arbeitet. Die Spannung einer stromgesteuerten Spannungsquelle wird mit der Ausgangsspannung des Messkreises seriegeschaltet. Gemeinsam treiben sie in einem Stromkreis einen Strom. Dieser Stromkreis umfasst eine Induktivität, deren meßstrombewirktes Feld durch einen mechanisch schwenkbar gelagerten Anker abgegriffen wird. Der Anker steuert über teilweise kapazitiv beschaltete Röhren eine Stromquelle an, deren Strom durch ein im erwähnten Stromkreis liegendes Impedanzelement als stromgesteuerte Spannungsquelle getrieben wird. Die gesteuerte Spannung stellt sich so ein, dass der im Stromkreis mit der auszumessenden Quelle getriebene Strom ausgeregelt wird. Nachteilig an diesem Messkreis ist die durch den Anker bewirkte Trägheit und die relativ grosse Messignalquellenbelastung. Die Eingangsimpedanz ergibt sich aus der Verstärkung des offenen Regelkreises und der Sensor-Induktivität.

Die vorliegende Erfindung setzt sich zum Ziel, einen Messkreis eingangs genannter Art so auszubilden, dass die zu messende Spannung praktisch unbelastet ist, die Impedanzverhältnisse am Messkreiseingang klar definiert sind und ein auch dynamisch gutes Folgeverhalten erreicht wird.

Dies wird bei Ausbildung nach dem kennzeichnenden Teil des Anspruchs 1 erreicht.

Obwohl es sich grundsätzlich um eine Spannungsmessung handelt, ergibt der Einsatz eines Stromverstärkers zur Messung eines durch die Differenz aus zu messender und Ausgangsspannung getriebenen Stromes mit einer bekannterweise bei Stromverstärkern verschwindenden Eingangsimpedanz klare Eingangsimpedanzverhältnisse. Mit dem zugeschalteten kapazitiven Impedanzelement wird erreicht, dass die Meßspannung praktisch unbelastet ist. Vorsehen des Stromverstärkers ermöglicht trotz des zugeschalteten kapazitiven Impedanzelementes eine eingangsseitige Spannungsverstärkung über Impedanzelement und Stromverstärker in der Grössenordnung von 1, womit keine nachmals zu kompensierende massgebliche Signalabschwächung im Regelkreis erfolgt.

Die erwähnte zu messende Spannung kann in einer Ausführungsvariante gemäss Anspruch 6, die über dem kapazitiven Impedanzelement durch einen an den Eingang des Stromverstärkers eingeführten elektrischen Strom oder eine elektrische Ladung erzeugte Spannung sein. Auch diese zu messende Spannung über dem kapazitiven Impedanzelement ist praktisch unbelastet. Sie ergibt sich aus der daraus ausgeflossenen Ladung bzw. dem Zeitintegral des ausgeflossenen Stromes.

Die Erfindung wird anschliessend beispielsweise anhand von Figuren erläutert.

Es zeigen:

Fig. 1 die Anordnung eines erfindungsgemässen Messkreises zur Spannungsmessung,

Fig. 2 die Anordnung eines erfindungsgemässen Messkreises zur auf eine Spannungsmessung zurückgeführten Erfassung eines Stromes oder einer Ladung,

Fig. 3 eine bevorzugte Ausführungsform des erfindungsgemässen Messkreises, zur Messung einer Spannungsquelle mit kapazitiver Innenimpedanz,

Fig. 4a das Ersatzbild einer extrem hochohmigen Spannungsquelle, als Einsatzbeispiel für den erfindungsgemässen Messkreis, wobei die Spannungsquelle durch eine isolierende Schicht und eine Metall-Elektrolytlösungs-Halbzelle gebildet ist,

Fig. 4b in Analogie zu Fig. 4a eine in Anwendung des erfindungsgemässen Messkreises messbare Spannungsquelle, bestehend aus zwei metallbeschichteten, isolierenden Schichten, mit oder ohne dazwischenliegender Elektrolytlösung.

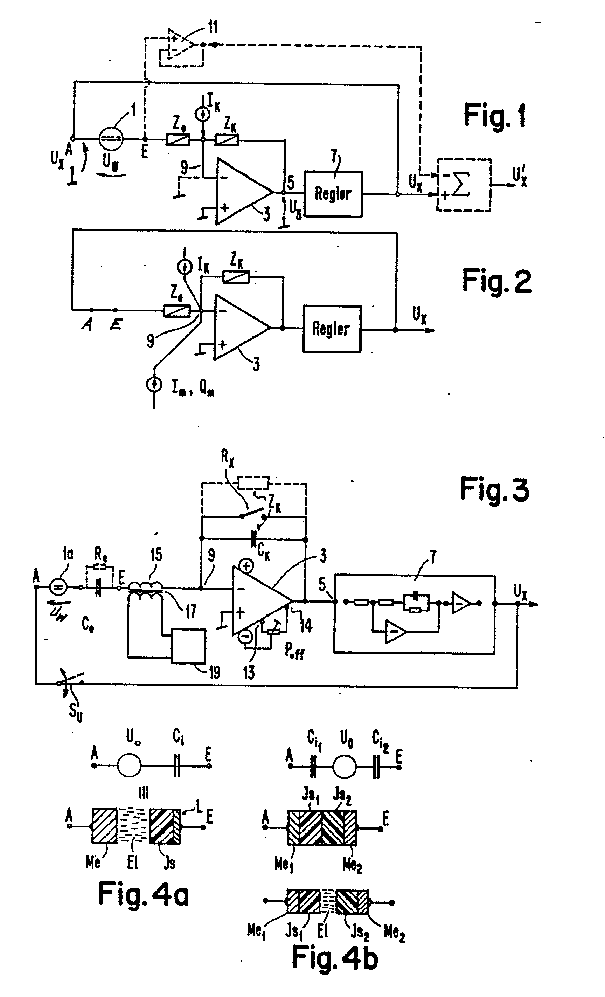

In Fig. 1 ist der Aufbau eines erfindungsgemässen Messkreises für die Messung der Spannung einer Spannungsquelle 1 dargestellt. Die Spannungsquelle 1 ist mit einem Anschluss mit dem Eingang E eines mit den Impedanzen $Z_e$ und $Z_k$ invertierend beschalteten Operationsverstärkers 3 verbunden. Der Ausgang 5 des Operationsverstärkers ist über einen Regler 7 auf den zweiten Anschluss A der Spannungsquelle 1, rückgeführt. Bei Aufschalten der eigentlich als Führungsgrösse wirkenden Spannung $U_w$ der Quelle 1 fliesst wegen des niederohmigen Rückführungsanschlusses an A und dem virtuell auf Masse geschalteten Stromsummationspunkt 9 des Operationsverstärkers 3 kurzzeitig ein Strom durch die Eingangsimpedanz $Z_e$ des Operationsverstärkers 3, von dort auf die Rückkopplungsimpedanz $Z_K$, so dass die Ausgangsspannung $U_5$, über den Regler 7 als Regelgrösse $U_x$ auf den Anschluss A rückgeführt, die an E anliegende Gesamtspannung rasch zu Null werden lässt. Der Frequenzgang des Reglers 7 wird nach Massgabe der Übertragungsfunktion des Operationsverstärkers 3 mit dem Gegenkopplungs-Netzwerk $Z_e$, $Z_k$ so gewählt, dass der offene Regelkreis, vorzugsweise PI- oder PID-Verhalten zeigt.

Es kann gezeigt werden, dass bei grosser Verstärkung des offenen Regelkreises ein Störstrom am Stromsummationspunkt 9 des Operationsverstärkers 3 praktisch ganz über die Eingangsimpedanz $Z_e$ abfliesst. Deshalb ist es insbesondere dann, wenn $Z_e$ hochohmig ist, angezeigt, einen Kompensationsstrom $I_K$ besagtem Anschluss zuzuführen. Eine andere Möglichkeit, den durch Eingangs-Störströme bewirkten Fehler zu berücksichtigen, besteht darin, die Spannung an der Eingangsimpedanz $Z_e$, wie mit dem Folger 11, in Fig. 1 angedeutet, abzugreifen und dieses Signal mit der gemessenen Regelgrösse $U_X$ zu verrechnen, um so zu einem praktisch fehlerfreien Ausgangssignal $U'_X$ zu gelangen. Diese Korrekturmöglichkeit ist selbstverständlich nur dann anwendbar, wenn der Anschluss E für die Spannungsquelle 1 überhaupt abgreifbar ist, d.h. dann, wenn die Innenimpedanz der Quelle 1 nicht den massgeblichen Anteil der Eingangsimpedanz des Operationsverstärkers 3 darstellt.

Da auch beim Vorsehen der Spannungsmesseinrichtung, entsprechend dem Folger 11 in Fig. 1, lediglich die kleine Regeldifferenz am Eingang dieser Vorrichtung liegt, erscheint deren Eingangsimpedanz ebenfalls um die Verstärkung des offenen Kreises erhöht als Belastung der Signalquelle 1. Ausser durch eine allfällige Streuimpedanz parallel über der Quelle 1, zwischen den Anschlüssen A und E liegend, und der Eingangsimpedanz $Z_e$ des Operationsverstärkers 3, allenfalls der Eingangsimpedanz der Spannungsmesseinrichtung 11, beide um die Verstärkung des offenen Kreises erhöht, ist die Quelle 1 nicht belastet. Die Parallelimpedanz über den Anschlüssen A und E kann durch entsprechende Auslegung der Abschirmung resp. der Isolation der verwendeten Kabel extrem hochohmig ausgelegt werden.

In Fig. 2 ist der Messkreis analog zu Fig. 1 dargestellt, wie er zur Messung von Strömen eingesetzt wird. Der zu messende Strom $I_m$ resp. die zu messende Ladung $Q_m$ wird dem Stromsummationspunkt 9 des Operationsverstärkers 3 zugeführt. Der Strom resp. die Ladung $I_m$, $Q_m$ fliesst auf die Eingangsimpedanz $Z_e$ und erzeugt eine Regelgrösse $U_x$, die der über letzterwähnten Impedanz erzeugten Spannung gleich ist. Insbesondere für die Messung extrem kleiner Ströme im Sub-Pico-Ampère-Bereich ist es dabei unumgänglich, den Eingangsfehlerstrom, beispielsweise erzeugt durch den Eingangsstrom des Verstärkers 3, vorgängig zu kompensieren.

In Fig. 3 ist eine bevorzugte Variante des Messkreises dargestellt. Als Operationsverstärker 3 ist dabei der Operationsverstärker ICH 8500/A mit MOS-FET-Eingangs-Differentialstufe und Eingangs-Schutzdioden der Firma Intersil verwendet, mit einem spezifizierten maximalen Eingangsruhestrom von 0,01 pA. Als Eingangsfehlerstrom-Kompensationsmittel entsprechend den in Fig. 1 und 2 dargestellten Quellen für die Kompensationsströme $I_K$ ist ein Potentiometer $P_{off}$ eingesetzt, zur Veränderung des Stromteilverhältnisses in der Eingangs-Differentialstufe, an Anschlüsse 13 und 14 geschaltet, mit dem Mittelabgriff auf negativer Speisespannung, wie dies für den Offset-Spannungsabgleich an diesem Verstärker vorgesehen ist. Der Ausgang 5 dieses Operationsverstärkers ist auf einen nichtinvertierenden PI-Regler geführt, in der schematisch bei 7 dargestellten Schaltungskonfiguration. Die Regelgrösse $U_x$ als Ausgangsspannung des Reglers 7, ist weiter über einen hochohmigen Unterbrecherschalter $S_u$ auf den Anschluss A für eine Gleichspannungsquelle 1a geführt, letztere über einen Kondensator $C_e$, mit grossem Leckwiderstand als Eingangsimpedanz des Verstärkers 3, auf den Anschluss E. Dieser Anschluss E ist weiter über die Sekundärseite 15 eines Hochfrequenzübertragers 17 auf den Stromsummationspunkt 9 des Operationsverstärkers 3 geführt. Der Übertrager 17 ist primärseitig als frequenzbestimmendes Netzwerk an einen emittergekoppelten Oszillator 19 geschaltet, wozu der integrierte Oszillator MC 1648 der Firma Motorola eingesetzt ist, betrieben auf einer Frequenz von ca. 80 MHz. Als Rückkopplungsimpedanz $Z_K$ ist eine kleine Kapazität mit grossem Leckwiderstand $C_k$ eingesetzt, überbrückt durch einen hochohmigen Rücksetzrelais-Kontakt $R_x$. Bei entsprechender Auslegung des Frequenzganges des PI-Reglers, nach üblichen Gesichtspunkten der Regelungstechnik und bei Vorgabe einer Eingangskapazität $C_e$ von ca. 5 pF bei einem Leckwiderstand $R_e$ von ca. $10^{15}$ Ohm ist es, nachdem sich der Messkreis thermisch stabilisiert hat und bei gut stabilisierter Speisespannung möglich, den Eingangsstörstrom mit dem Potentiometer $P_{off}$ auf Werte kleiner als $10^{-16}$ A abzugleichen, was einer Spannungsdrift von weniger als 2 mV/s entspricht.

Der Unterbrecherschalter $S_u$ hat folgende Funktion:

Wird als auszumessende Quelle eine extrem hochohmige, praktisch kapazitive Quelle eingesetzt, so muss sichergestellt werden, dass vor Inbetriebnahme des Messregelkreises durch Oeffnen des Rücksetzschalters $R_x$ nicht eine Aufladung der Quellen-Innen-Kapazität entsprechend $C_e$ erfolgt. Zu diesem Zweck wird vor Anschliessen der auszumessenden Quelle an den Anschlüssen A und E der Schalter $S_u$ geöffnet und stellt somit eine Kapazität dar, die wesentlich kleiner ist als die Kapazität der Quellen-Innenimpedanz, entsprechend $C_e$. Damit lädt die auszumessende Quelle lediglich die durch den Schalter $S_u$ gebildete Schalterkapazität auf. Danach kann der Messregelkreis durch Öffnen des Rücksetzschalters $R_x$ in Betrieb genommen werden, allerdings mit noch geringer, durch die kleine Kapazität des Schalters $S_u$ mitbestimmter Kreisverstärkung. Nach Schliessen des Unterbrecherschalters $S_u$ springt jedoch die Regelgrösse $U_x$ auf den Spannungswert der Spannungsquelle, entsprechend 1a von Fig. 3. Nach diesem Verfahren wurden Einstellgenauigkeiten der Regelgrössen $U_x$ auf die auszumessende Spannung entsprechend der Quelle 1a, von ca. 50‰ erzielt.

Der beschriebene Messkreis eignet sich nun ausgezeichnet für das Ausmessen von Kontaktspannungen, wie von Thermospannungen oder elektrochemischen Spannungen, bei welchen schon der geringste Stromfluss eine Änderung bewirkt.

In Fig. 4a ist das Ersatzbild einer extrem hochohmigen resp. kapazitiven Spannungsquelle mit der idealen Spannungsquelle $U_0$ und der Innenkapazität $C_i$ dargestellt. Zur Ausmessung einer elektrochemischen Halbzellenspannung wird eine solche kapazitive Spannungsquelle, wie in Fig. 4a dargestellt, beispielsweise so realisiert:

Die Halbzelle aus dem Metall Me und der Elektrolytlösung El sei auszumessen. Dann wird als Abgriff eine Isolationsschicht Js, die einerseits mit der Elektrolytlösung El kontaktiert wird und anderseits mit einer Leiterschicht L versehen ist, eingesetzt. Die elektrischen Abgriffe der Ganzzelle für das Anschliessen an den Messkreis, und zwar an den in Fig 3 dargestellten Anschlüssen A und E, werden einerseits am Metall Me, anderseits an der Leiterschicht L, beispielsweise ebenfalls aus Metall, angebracht. Die vornehmlich zwischen Metall und Elektrolytlösung sich bildende Kontaktspannung $U_o$ wird mit Hilfe des durch die Isolationsschicht Js und die Leiterschicht L gebildeten kapazitiven Abgriffs an einem Messkreis, wie beispielsweise in Fig. 3 dargestellt, messbar.

Wie in Fig. 4b dargestellt, kann mit dem, beispielsweise in Fig. 3 dargestellten, Messkreis auch die Kontaktspannung zwischen Isolatoren $Js_1$ und $Js_2$ resp. die resultierende Kontaktspannungsdifferenz, beispielsweise zwischen Isolatoren und einer Elektrolytlösung gemessen werden.

Rückblickend auf die in Fig. 2 dargestellte Möglichkeit zur Strommessung mit Hilfe des Messkreises muss noch darauf hingewiesen werden, dass der Messtrom $I_m$ nicht unbedingt extern zugeführt zu werden braucht, sondern auch direkt der Eingangsstrom des verwendeten Verstärkers 3 sein kann, womit es mit diesem Messkreis möglich ist, den Eingangsstrom eines als Eingangsverstärker eingesetzten zu prüfenden Verstärkers 3 zu messen. Dies insbesondere bei extrem kleinen Eingangsströmen. Wird in Fig. 2 die Eingangsimpedanz $Z_e$ als Kapazität ausgelegt, so ergibt sich als Messignal resp. Regelgrösse $U_x$ das Zeitintegral des auf den Summationspunkt 9 fliessenden Stromes, d.h. aus der Anstiegssteilheit der resultierenden Spannungsrampe kann auf den einfliessenden Strom geschlossen werden.

Der beschriebene Messkreis kann in Geräten der Analysetechnik verwendet werden, überall dort, wo extrem kleine Belastungen einer auszumessenden Spannungsquelle erforderlich sind. Mit entsprechenden kapazitiven Abgriffen dürfte damit insbesondere die Dynamik des Aufbaus von Kontaktspannungen, beispielsweise zwischen Metallen und Elektrolytlösungen messbar werden. Entscheidend für die Langzeitgenauigkeit ist dabei die Genauigkeit, mit welcher Eingangsfehlerströme abgeglichen werden können, wie oben beschrieben wurde.

## Patentansprüche

1. Serie-parallel gegengekoppelter Messkreis zum Messen einer elektrischen Spannung ($U_w$; 1a), wobei die zu messende Spannung ($U_w$; 1a) in Serie mit einer ihr gegenwirkenden Ausgangsspannung ($U_x$) des Messkreises auf einen Eingang (9) eines Verstärkers (3) wirkt und die Ausgangsspannung ($U_x$) als Messignal abgegriffen wird, dadurch gekennzeichnet, dass der Verstärker (3) zur Messung eines durch die Differenz aus zu messender Spannung ($U_w$; 1a) und Ausgangsspannung ($U_x$) getriebenen Stromes als parallel-parallel gegengekoppelter, integrierender Stromverstärker (3; $Z_K$) ausgebildet ist und dass die Ausgangsspannung ($U_x$) in Serie mit der zu messenden Spannung ($U_w$; 1a) über ein zugeschaltetes kapazitives Impedanzelement ($Z_e$; $C_e$; $R_e$; $C_i$.) auf den Eingang (9) des Stromverstärkers (3; $Z_K$) geschaltet ist.

2. Messkreis nach Anspruch 1, dadurch gekennzeichnet, dass dem Stromverstärker (3; $Z_K$) ein PI- oder PID-Regler (7) nachgeschaltet ist, dessen Ausgangsspannung die gegenwirkende Ausgangsspannung ($U_x$) ist.

3. Messkreis nach einem der Ansprüche 1 oder 2, zur Messung einer elektrischen Spannung einer Spannungsquelle (1; 1a), dadurch gekennzeichnet, dass getrennte Anschlüsse (A, E) vorgesehen sind, zum Zuschalten der Spannungsquelle mit der Quellenspannung als zu messende elektrische Spannung ($U_w$) in Serie zu der Ausgangsspannung ($U_x$).

4. Messkreis nach Anspruch 3, dadurch gekennzeichnet, dass das zugeschaltete kapazitive Impedanzelement die Innenimpedanz ($R_e$; $C_e$) der Spannungsquelle (1a) ist.

5. Messkreis nach Anspruch 1, dadurch gekennzeichnet, dass eine Spannungsmesseinrichtung (11) zum Messen einer über dem zugeschalteten kapazitiven Impedanzelement ($Z_e$) liegenden Fehlerspannung vorgesehen ist.

6. Messkreis nach einem der Ansprüche 1 oder 2, dadurch gekennzeichnet, dass ein Eingang für einen zu erfassenden Strom ($I_m$) oder eine zu erfassende Ladung ($Q_m$) am Stromverstärkereingang (9) vorgesehen ist und dass ein an diesem Eingang zugeführter Strom bzw. eine dort zugeführte Ladung durch Messung der dadurch am kapazitiven Impedanzelement ($Z_e$) bewirkten Spannung erfasst wird.

7. Messkreis nach einem der Ansprüche 1 bis 6, dadurch gekennzeichnet, dass Kompensationsmittel ($I_k$, $P_{off}$; 15, 17, 19) für einen Eingangsfehlerstrom des Stromverstärkers (3; $Z_K$) vorgesehen sind.

8. Messkreis nach Ansprüche 7, dadurch gekennzeichnet, dass die Kompensationsmittel eine AC-Signalquelle (17) umfassen, die in Serie zu der zu messenden Spannung ($U_w$) sowie zur Ausgangsspannung ($U_x$) geschaltet ist und deren Signalfrequenz vorzugsweise grösser ist als die Transitfrequenz des Stromverstärkers (3).

9. Messkreis nach Anspruch 8, dadurch gekennzeichnet, dass die AC-Signalquelle (17) einen transformatorischen Übertrager (15) umfasst, dessen Sekundärseite in Serie zur Ausgangsspannung ($U_x$) und zu der zu messenden Spannung ($U_w$) geschaltet ist.

## Claims

1. Series-parallel negative feedback measuring circuit for measuring an electric voltage ($U_w$; 1a), in which the voltage ($U_w$; 1a) to be measured is active, in series with an opposing output voltage ($U_x$) of the measuring circuit, upon the input (9) of an amplifier (3), and wherein the output voltage ($U_x$) is a measuring signal, characterised in that the amplifier (3) for measuring a current driven by the difference between voltage ($U_w$; 1a) to be measured and output voltage ($U_x$) is a parallelparallel negative feedback integrating current amplifier (3; $Z_K$), and in that the output voltage ($U_x$) is connected, in series with the voltage ($U_w$; 1a) to be measured, to the input (9) of the current amplifier (3; $Z_K$) via a connected capactive impedance element ($Z_e$; $C_e$; $R_e$; $C_i$).

2. Measuring circuit as per claim 1, characterised in that a PI or PID regulator (7) is arranged downstream of the current amplifier (3; $Z_K$), the output voltage of the regulator being the opposing output voltage ($U_x$).

3. Measuring circuit according to one of claims 1 or 2, for measuring an electric voltage of a voltage source (1; 1a), characterised in that separate connections (A, E) are provided for connecting the voltage source in series to the output voltage ($U_x$), the source voltage being the electrical voltage ($U_w$) to be measured.

4. Measuring circuit according to claim 3, characterised in that the connected capacitive impedance element is the internal impedance ($R_e$; $C_e$) of the voltage source (1a).

5. Measuring circuit according to claim 1, characterised in that a voltage measuring facility (11) is provided for measuring an error voltage across the connected capacitive impedance element ($Z_e$).

6. Measuring circuit according to one of claims 1 or 2, characterised in that an input is provided at the current amplifier input (9) for a current ($I_m$) to be recorded or a charge ($Q_m$) to be recorded, and in that a current or charge supplied to this input is recorded by measuring the resulting voltage occurring on the capacitive impedance element ($Z_e$).

7. Measuring circuit according to one of claims 1 to 6, characterised in that compensation means ($I_K$, $F_{off}$; 15, 17, 19) are provided for an input leakage current of the current amplifier (3; $Z_K$).

8. Measuring circuit according to claim 7, characterised in that the compensation means comprise an AC signal source (17) which is connected in series to the voltage ($U_w$) to be measured and to the output voltage ($U_x$), and whose signal frequency is preferably greater than the transit frequency of the current amplifier (3).

9. Measuring circuit according to claim 8, characterised in that the AC signal source (17) comprises a transformer-type transducer (15) the secondary end of which is connected in series to the output voltage ($U_x$) and to the voltage ($U_w$) to be measured.

**Revendications**

1. Circuit de mesure à contre-réaction série-parallèle pour la mesure d'une tension électrique ($U_w$; 1a), dans lequel la tension à mesurer ($U_w$; 1a) agit en série avec une tension de sortie ($U_x$), à action opposée du circuit de mesure sur une entrée (9) d'un amplificateur (3) et dans lequel la tension de sortie ($U_x$) est prélevée en tant que signal de mesure, caractérisé en ce que l'amplificateur (3) est réalisé, pour la mesure d'un courant produit par la différence de la tension à mesurer ($U_w$; 1a) et de la tension de sortie ($U_x$), sous la forme d'un amplificateur de courant (3; $Z_K$) à contre-réaction parallèle-parallèle, réalisant une intégration et en ce que la tension de sortie ($U_x$) est appliquée, en série avec la tension à mesurer ($U_w$; 1a), par l'intermédiaire d'un élément d'impédance capacitif ($Z_e$; $C_e$; $R_e$; $C_i$) rapporté à l'entrée (9) de l'amplificateur de courant (3; $Z_K$).

2. Circuit de mesure selon la revendication 1, caractérisé en ce qu'en aval de l'amplificateur de courant (3; $Z_K$) se trouve branché un régulateur (7) à action proportionnelle et intégrale ou à action proportionnelle, intégrale et différentielle et dont la tension de sortie est ladite tension de sortie ($U_x$) à action opposée.

3. Circuit de mesure selon l'une des revendications 1 ou 2, pour la mesure d'une tension électrique d'une source de tension (1; 1a), caractérisé en ce qu'il est prévu des bornes séparées (A, E) pour le branchement additionnel de la source de tension, dont la tension est, en tant que tension électrique à mesurer ($U_w$), en série avec la tension de sortie ($U_x$).

4. Circuit de mesure selon la revendication 3, caractérisé en ce que l'élément d'impédance capacitif rapporté est l'impédance interne ($R_e$; $C_e$) de la source de tension (1a).

5. Circuit de mesure selon la revendication 1, caractérisé en ce qu'il est prévu un dispositif de mesure de tension (11) pour mesurer une tension de défaut appliquée aux bornes de l'élément d'impédance capacitif ($Z_e$) rapporte.

6. Circuit de mesure selon l'une des revendications 1 ou 2, caractérisé en ce qu'il est prévu une entrée pour un courant à détecter ($I_m$) ou pour une charge à détecter ($Q_m$) à l'entrée (9) de l'amplificateur de courant et en ce qu'un courant envoyé à cette entrée ou une charge appliquée sur cette dernière est détecté par mesure de la tension obtenue de ce fait aux bornes de l'élément d'impédance capacitif ($Z_e$).

7. Circuit de mesure selon l'une des revendications 1 à 6, caractérisé en ce que des moyens de compensation ($I_K$, $P_{off}$; 15, 17, 19) sont prévus pour un courant de défaut d'entrée de l'amplificateur de courant (3; $Z_K$).

8. Circuit de mesure selon la revendication 7, caractérisé en ce que les moyens de compensation comprennent une source de signaux de courant alternatif (17), qui est branchée en série avec la tension à mesurer ($U_w$) ainsi qu'avec la tension de sortie ($U_x$) et dont la

fréquence des signaux est de préférence supérieure à la fréquence de transit de l'amplificateur de courant (3).

9. Circuit de mesure selon la revendication 8, caractérisé en ce que la source de signaux de courant alternatif (17) comprend un transformateur (15), dont l'enroulement secondaire est branché en série avec la tension de sortie ($U_x$) et avec la tension à mesurer ($U_w$).

# Fig.1

# Fig.2

# Fig.3

# Fig.4a

# Fig.4b